**Europäisches Patentamt**

(19) **European Patent Office**

**Office européen des brevets**

(11) Numéro de publication: **0 263 751**
**B1**

(12) **FASCICULE DE BREVET EUROPEEN**

(45) Date de publication du fascicule du brevet:
**19.12.90**

(21) Numéro de dépôt: **87402196.7**

(22) Date de dépôt: **02.10.87**

(51) Int. Cl.⁵: **H03M 1/46**

(54) Convertisseur analogique-numérique à capacités commutées.

(30) Priorité: **07.10.86 FR 8613935**

(43) Date de publication de la demande:
**13.04.88 Bulletin 88/15**

(45) Mention de la délivrance du brevet:
**19.12.90 Bulletin 90/51**

(84) Etats contractants désignés:
**CH DE FR GB IT LI NL**

(56) Documents cités:
**IEEE JOURNAL OF SOLID-STATE CIRCUITS, vol.
SC-10, no. 6, Décembre 1975, pages 497-499, New York,
US; P.R. GRAY et al.: "Companded pulse-code
modulation voice codec using monolithic weighted
capacitor arrays"**

(73) Titulaire: **THOMSON SEMICONDUCTEURS, 101, bld
Murat, F-75016 - Paris(FR)**

(72) Inventeur: **Bernard, Patrick, THOMSON-CSF
SCPI 19, avenue de Messine, F-75008 Paris(FR)**

(74) Mandataire: **de Beaumont, Michel, 1bis, rue
Champollion, F-38000 Grenoble(FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

L'invention concerne un convertisseur analogique-numérique fonctionnant selon le principe des circuits à capacités commutées, c'est à dire utilisant des transferts de charges électriques élémentaires depuis des capacités d'entrée vers des capacités de sortie.

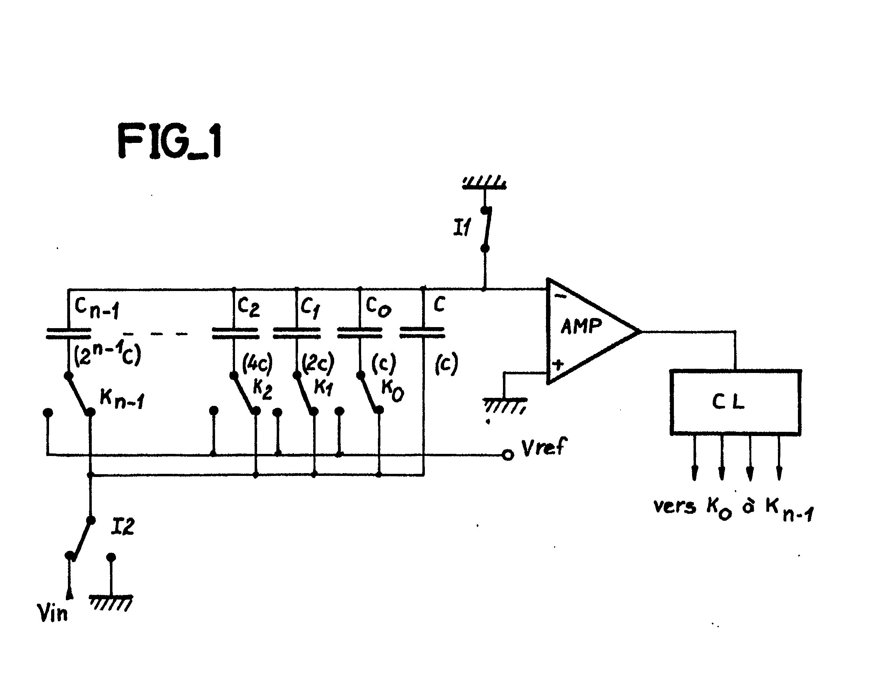

Un schéma connu de convertisseur à capacités commutées est représenté à la figure 1.

Ce convertisseur travaille sous le controle d'une horloge définissant une fréquence d'échantillonnage F, et la conversion est effectuée en n+1 cycles d'horloge, où n est un nombre entier qui définit la précision de la conversion.

Le circuit comporte n capacités $C_0$ à $C_{n-1}$ pondérées selon un code binaire pur, la capacité la plus faible ayant une valeur c et les autres ayant des valeurs respectives $2c, 4c, ...2^{n-1}c$; en outre une autre capacité de valeur de base c est prévue.

Toutes les capacités ont une armature commune reliée à l'entrée inverseuse d'un amplificateur différentiel dont l'autre entrée (non-inverseuse) est reliée à la masse.

L'autre armature de chaque capacité peut être reliée soit à la masse, soit à un potentiel de référence Vréf, soit encore à la tension analogique d'entrée Vin que l'on cherche à convertir. Enfin, l'entrée inverseuse de l'amplificateur peut être reliée à la masse par un interrupteur.

Le fonctionnement est le suivant:

Pendant une première phase, l'entrée inverseuse de l'amplificateur étant à la masse, on applique à toutes les capacités le potentiel Vin à convertir; puis on déconnecte de la masse l'entrée de l'amplificateur de sorte qu'une charge globale reste stockée sur les armatures des capacités qui restent connectées à l'entrée de l'amplificateur.

Pendant une deuxième phase, on connecte la capacité de plus fort poids au potentiel de référence Vréf, tandis que toutes les autres sont mises à la masse. Selon la valeur du potentiel Vin (par rapport à Vréf), le signal de sortie de l'amplificateur bascule dans un sens positif ou négatif, et ce basculement est utilisé pour connecter la capacité de poids le plus fort (poids n-1) soit à la masse soit à Vréf pendant tout le reste de la conversion.

Pendant une troisième phase, c'est la capacité de poids immédiatement inférieur (poids n-2) qui est connectée à Vréf pendant que les capacités de poids plus faible sont à la masse; là encore ,le sens de basculement de l'amplificateur définit si cette capacité de poids n-2 sera connectée à la masse ou à Vréf pendant tout le reste de la conversion.

Pendant les phases suivantes, les capacités de poids successifs décroissants sont ainsi reliées à Vréf puis mises à la masse ou laissées à Vréf selon le sens de basculement de l'amplificateur.

A la fin de la conversion (phase n+1), l'état des interrupteurs connectant les différentes capacités à la masse ou à Vréf définit un code binaire représentant une valeur numérique de la tension analogique Vin à convertir.

Ce schéma de circuit est adapté à la conversion de tensions analogiques à la condition que ces tensions soient référencées par rapport à la masse (en rappelant que l'amplificateur a une entrée non-inverseuse reliée en permanence à la masse et une entrée inverseuse reliée à la masse pendant la première phase).

Si l'on veut convertir sous forme numérique une tension différentielle non référencée par rapport à la masse, on est obligé de transformer d'abord cette tension en une tension non différentielle, référencée par rapport à la masse. Cette transformation nécessite un amplificateur différentiel supplémentaire qu'il serait souhaitable d'éviter.

La présente invention propose un circuit de conversion à capacités commutées capable de réaliser des conversions de tensions différentielles sans nécessiter d'amplificateur différentiel supplémentaire.

Selon l'invention, on prévoit essentiellement une capacité supplémentaire de valeur sensiblement égale à la somme des autres capacités pondérées du schéma, et des phases de commutation et connection des capacités qui vont être décrites ci-après.

Le schéma selon l'invention comprend plus précisément:

- une entrée E+ et une entrée E-, ainsi qu'une masse, une tension analogique à convertir étant appliquée entre l'entrée E+ et l'entrée E-.
- un amplificateur différentiel à grand gain, ayant une entrée non-inverseuse reliée à la masse et une entrée inverseuse;
- un premier commutateur pour relier à la masse ou non l'entrée inverseuse;
- une série de capacités ayant toutes une armature reliée pendant la conversion à l'entrée inverseuse de l'amplificateur;
- une série de commutateurs pour relier l'autre armature de chaque capacité, sauf celle de poids le plus fort, soit à un premier noeud du circuit soit à un second noeud, le second noeud étant relié à un premier potentiel de référence;
- un deuxième commutateur pour relier le premier noeud soit à l'entrée E+ soit à un deuxième potentiel de référence;
- un troisième commutateur pour relier l'autre armature de la capacité de poids le plus fort soit à l'entrée E- soit à un troisième potentiel de référence;

De préférence, le circuit comprend en outre une capacité supplémentaire de valeur égale à la capacité de plus faible poids de la série, cette capacité ayant une armature connectée à l'entrée inverseuse de l'amplificateur différentiel et l'autre armature connectée au premier noeud du circuit.

Dans un premier mode de réalisation, le deuxième et le troisième potentiels de référence sont constitués par la masse; mais alors il est nécessaire de commencer toute étape de conversion en vérifiant que la tension analogique appliquée entre les entrées E+ et E- est bien de même signe que la différence de potentiel entre le deuxième potentiel de référence et la masse. L'amplificateur peut servir à faire cette comparaison préliminaire et à commander, si c'est nécessaire une inversion de la polarité de la tension analogique appliquée entre les entrées E+ et E-.

Il est préférable de prévoir alors une modification du circuit selon laquelle une capacité supplémentaire est prévue, cette capacité ayant une valeur moitié de la capacité de plus faible poids de la série; cette capacité est commutée entre le premier potentiel de référence et la masse.

Dans un autre mode de réalisation, le premier potentiel de référence est un potentiel positif +Vréf, le deuxième est un potentiel négatif -Vréf de même valeur que le premier, et le troisième est la masse.

D'autres caractéristiques et avantages de l'invention apparaîtront à la lecture de la description détaillée qui suit et qui est faite en référence aux dessins annexés dans lesquels:

- la figure 1 déjà décrite représente un circuit de conversion connu;
- la figure 2 représente un premier mode de réalisation de l'invention;
- la figure 3 représente un deuxième mode de réalisation;

Le schéma de base de l'invention reprend les éléments principaux du schéma de la figure 1. Il comprend en effet un amplificateur différentiel à grand gain AMP, ayant une entrée inverseuse désignée par le signe - et une entrée non-inverseuse désignée par le signe + , avec une série de capacités $C_0$, $C_1$, $C_2$ ...$C_{n-1}$, ayant toutes une armature reliée à l'entrée inverseuse de l'amplificateur; les capacités ont de préférence des valeurs pondérées selon un code binaire, auquel cas la capacité de poids inférieur $C_0$ a une valeur c, la capacité de poids immédiatement supérieur a une valeur 2c, les autres des valeurs successives 4c, 8c, etc.

La série de capacités est complétée par une capacité supplémentaire $C_n$ (qui n'existait pas dans le schéma de la figure 1), cette capacité ayant une valeur qui est sensiblement la somme des autres capacités de la série et qui , dans le cas plus précis d'une pondération binaire des capacités de la série, a une valeur $2^n c$. La capacité $C_n$ a comme les autres une armature reliée à l'entrée inverseuse de l'amplificateur.

L'autre armature de chaque capacité $C_0$ à $C_{n-1}$ est reliée à un commutateur respectif, $K_0$ à $K_{n-1}$, qui peut la relier soit à un noeud A, soit à un noeud B.

Le noeud A est relié à un commutateur I2 qui permet de connecter ce noeud soit à une première entrée E+ du circuit soit à un potentiel de référence qui, dans cet exemple de réalisation, est la masse.

Le noeud B est relié à un autre potentiel de référence désigné par Vréf.

L'autre armature de la capacité de poids le plus fort, c'est à dire la capacité $C_n$ est reliée à un commutateur I3 qui permet de la connector soit à une deuxième entrée E- du circuit soit à un troisième potentiel de référence qui dans cet exemple de réalisation est encore la masse.

Le circuit comporte par ailleurs un interrupteur I1 pour connecter à la masse ou déconnecter de la masse l'entrée inverseuse de l'amplificateur.

Enfin le circuit comporte deux éléments supplémentaires:
- une capacité C de valeur égale à la capacité de plus faible poids de la série, c'est-à-dire c, cette capacité étant connectée entre le noeud A et l'entrée inverseuse de l'amplificateur; la capacité $C_n$ est en fait égale à la somme de cette capacité C et de la série de capacités pondérées $C_0$ à $C_{n-1}$;
- un circuit logique CL dont on expliquera le fonctionnement en détail et dont le rôle principal est de commander les différents commutateurs pour exécuter une séquence de conversion.

Le fonctionnement du circuit est le suivant: une tension analogique à convertir est appliquée entre l'entrée E+ et l'entrée E- du circuit; c'est la valeur de cette tension qui sera convertie, quelle que soit la référence de cette tension par rapport à la masse.

Pendant une première phase, tous les commutateurs $K_0$ à $K_{n-1}$ relient les armatures des capacités $C_0$ à $C_{n-1}$ au noeud A; de plus, le commutateur I1 relie l'entrée inverseuse de l'amplificateur à la masse; le commutateur I2 relie le noeud A à l'entrée E+; enfin, le commutateur I3 relie la capacité de poids le plus fort $C_n$ à la masse.

A la fin de cette première phase, une charge électrique est stockée à l'entrée inverseuse de l'amplificateur. On piège cette charge en ouvrant l'interrupteur I1 avant d'ouvrir tout autre commutateur.

La deuxième phase consiste, après ouverture de l'interrupteur I1, à relier le noeud A à la masse par le commutateur I2, à relier la capacité $C_n$ de poids le plus fort à l'entrée E- par le commutateur I3, et à relier la capacité $C_{n-1}$, par le commutateur $K_{n-1}$, au noeud B, c'est-à-dire au potentiel Vréf. Le calcul montre qu'en fonction de la charge stockée durant la première phase, une différence de potentiel s'établit à l'entée de l'amplificateur et que le signe de cette différence de potentiel est est le signe de la différence entre la tension appliquée entre les entrées E+ et E- et la moitié de la tension de référence Vréf.

La tension différentielle d'entrée est donc comparée à Vréf/2 et l'amplificateur à grand gain bascule dans un sens ou dans l'autre selon le résultat de la comparaison.

Les phases suivantes dépendent à chaque fois du résultat de la phase précédente et il y a n+1 phases pour effectuer la conversion.

Ainsi, si dans la deuxième phase on a déterminé que la tension appliquée est supérieure à Vréf/2, alors, l'interrupteur $K_{n-1}$ restera connecté pour les phases suivantes au potentiel Vréf, tandis que si la tension appliquée est inférieure àVréf/2, alors l'interrupteur $K_{n-1}$ restera connecté pendant les phases suivantes au noeud A c'est-à-dire à la masse.

La i-1ème phase consiste à relier la capacité $C_{ni+1}$, par l'interrupteur $K_{n-i+1}$, à Vréf, les capacités de rang inférieur étant connectées au noeud A donc à la masse et les capacités de rang supérieur étant connectées à Vréf ou au noeud A selon le résultat des phases précédentes.

C'est le circuit logique CL qui effectue le séquencement des opérations en basculant les commutateurs en fonction des signaux produits à chaque phase par l'amplificateur AMP.

A la fin de la phase $n+1$, l'état des commutateurs $K_o$ à $K_{n-1}$ représente une valeur numérique codée en binaire de la tension analogique appliquée entre les entrées E+ et E-. Le poids affecté à chaque commutateur est le poids de la capacité à laquelle il est connecté.

Si la valeur numérique définie par l'état des commutateurs est k, alors la tension analogique d'entrée a une valeur $kV_{réf}/2^n$.

Il est à noter que le sens de la tension différentielle appliquée doit être tel que l'entrée E+ soit à un potentiel plus positif que l'entrée E- si le potentiel Vréf est positif par rapport à la masse. Si la tension avait un sens inverse, il faudrait l'inverser avant de l'appliquer; si le sens est inconnu a priori, on peut prévoir que le circuit est agencé pour fonctionner avec une phase préliminaire dans laquelle la tension est appliquée à l'entrée de l'amplificateur et le sens de basculement de l'amplificateur permet de commander ou non l'inversion du sens de la tension différentielle à convertir.

Toutefois, si on utilise cette méthode, la conversion analogique numérique produit un code zéro pour une valeur de tension d'entrée comprise entr -$V_{réf}/2^n$ et $+V_{réf}/2^n$, alors qu'il serait préférable que le code zéro corresponde à une tension d'entrée comprise entre $-V_{réf}/2^{n+1}$ et $+V_{réf}/2^{n+1}$.

Pour obtenir ce dernier résultat, on propose de prévoir une capacité supplémentaire, de valeur c/2, c'est-à-dire la moitié de la capacité de plus faible poids de la série, cette capacité étant connectée au potentiel Vréf pendant la première phase et à la masse pendant les phases suivantes.

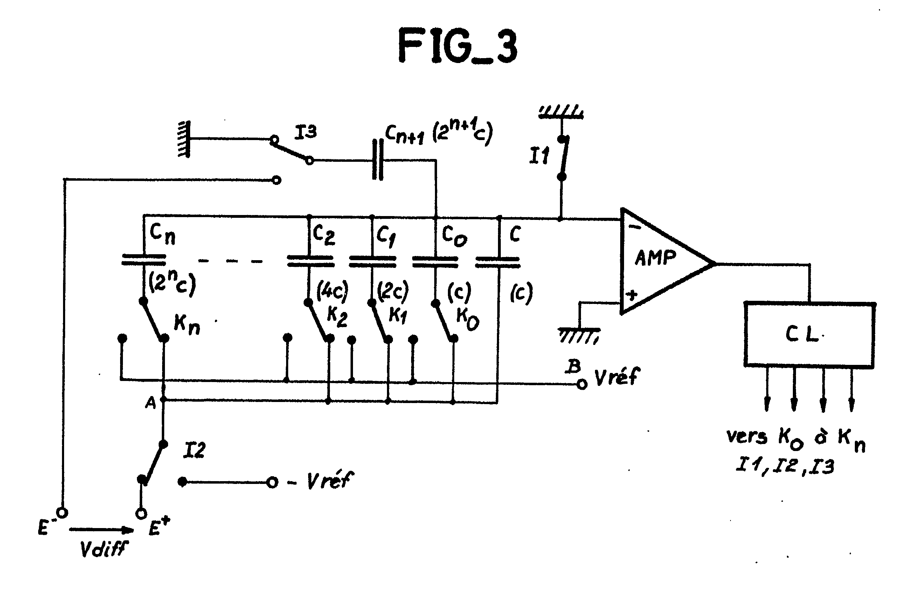

La figure 3 représente une variante de réalisation permettant d'une manière simple de prendre en compte aussi bien des tensions positives que des tensions négatives entre les entrées E+ et E- du circuit.

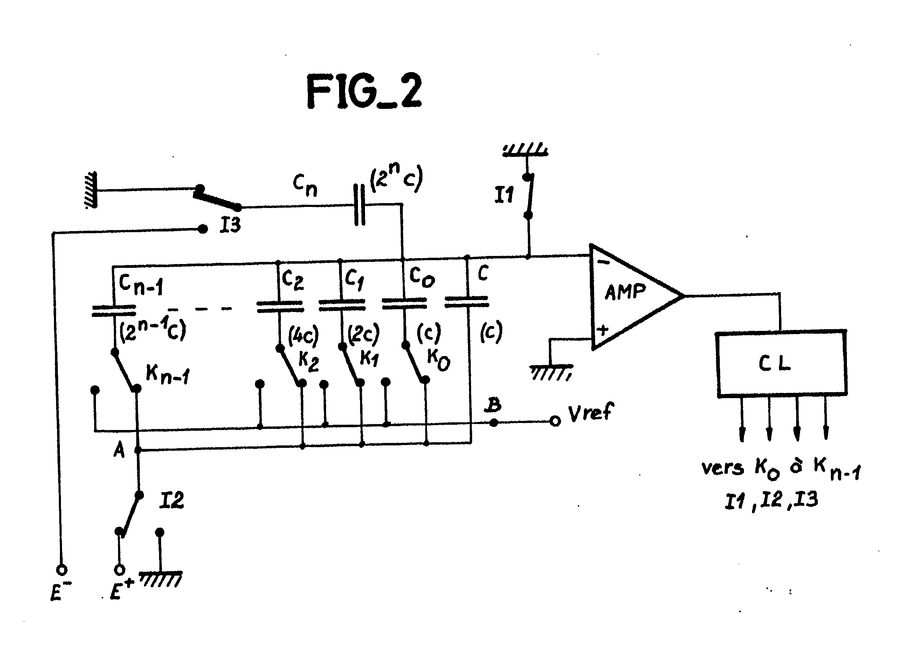

Cette réalisation diffère de celle de la figure 2 sur deux points:
- d'abord le potentiel de référence auquel peut être relié le noeud A par le commutateur I2 n'est plus la masse, mais c'est un potentiel -Vréf, qui est égal au potentiel Vréf mais de signe opposé (le potentiel nul de référence étant la masse).
- ensuite, mais seulement si on désire la même précision qu'à la figure 2 aussi bien pour des tensions négatives que pour des tensions positives à l'entrée du circuit, il faut prévoir une capacité de plus dans la série des capacités pondérées reliées par un interrupteur soit au noeud A soit au potentiel Vréf.

Sur le schéma de la figure 3, on a prévu dans cette série $n+1$ capacités pondérées, $C_o$ à $C_n$, de valeurs c à $2^n c$, reliées par des interrupteurs $K_o$ à $K_n$ soit au noeud A soit au noeud B; une capacité supplémentaire C de valeur c, directement connectée au noeud A, est encore prévue comme à la figure 2; enfin la capacité reliée entre l'entrée inverseuse de l'amplificateur et l'interrupteur I3 est maintenant une capacité $C_{n+1}$, de valeur $2^{n+1}c$ puisqu'elle doit ètre

égale en principe à la somme des capacités pondérées et de la capacité supplémentaire C.

Le fonctionnement du schéma de la figure 3 est le même que celui de la figure 2 mais il y a $n+2$ phases au lieu de $n+1$ puisqu'on a augmenté la dynamique maximale de conversion. L'état des commutateurs à la fin de la phase $n+2$ définit la valeur numérique, signée, de la tension analogique appliquée entre les entrées E+ et E-. Le bit de signe est défini par l'état du commutateur $K_n$.

## Revendications

1. Convertisseur analogique-numérique comprenant
- une entrée E+ et une entrée E-, ainsi qu'une masse, une tension analogique à convertir étant appliquée entre l'entrée E+ et l'entrée E-.
- un amplificateur différentiel à grand gain (AMP), ayant une entrée non-inverseuse reliée à la masse et une entrée inverseuse;
- un premier commutateur (I1) pour relier à la masse ou non l'entrée inverseuse;
- une série de capacités ($C_o$ à $C_n$, figure 2; $C_o$ à $C_{n+1}$, figure 3) ayant toutes une armature reliée pendant la conversion à l'entrée inverseuse de l'amplificateur;
- une série de commutateurs ($K_o$ à $K_{n-1}$, figure 2; $K_o$ à $K_n$, figure 3) pour relier l'autre armature de chaque capacité, sauf celle de poids le plus fort ($C_n$, figure 2; $C_{n+1}$, figure 3), soit à un premier noeud (A) du circuit soit à un second noeud (B), le second noeud étant relié à un premier potentiel de référence (Vréf);
- un deuxième commutateur (I2) pour relier le premier noeud soit à l'entrée E+ soit à un deuxième potentiel de référence;
caractérisé en ce qu'il comprend un troisième commutateur (I3) pour relier l'autre armature de la capacité de poids le plus fort ($C_n$, figure 2, $C_{n+1}$, figure 3) soit à l'entrée E- soit à un troisième potentiel de référence.

2. Convertisseur selon la revendication 1, caractérisé en ce que le deuxième et le troisième potentiels de référence sont constitués par la masse.

3. Convertisseur selon la revendication 2, caractérisé par le fait qu'il est prévu une capacité supplémentaire (C') de valeur égale à la moitié de la capacité de plus faible poids de la série, cette capacité étant commutée entre le premier potentiel de référence et la masse.

4. Convertisseur selon la revendication 1, caractérisé en ce que le premier potentiel de référence est un potentiel positif +Vréf, le deuxième est un potentiel négatif -Vréf de mème valeur que le premier, et le troisième est la masse.

## Patentansprüche

1. Analog/Digital-Wandler, der unfaßt:
- einen Eingangsanschluß E+ und einen Eingangsanschluß E- sowie einen Masseanschluß, wobei eine zu wandelnde analoge Spannung über den Eingangsanschlüssen E+ und E- angelegt wird;

– einen Differentialverstärker (AMP) mit großer Verstärkung, mit einem nicht-invertierenden Eingangsanschluß an Masse und einem invertierenden Eingangsanschluß;

– einen ersten Schalter (I1), um den invertierenden Eingangsanschluß auf Masse zu ziehen oder nicht;

– einen Satz Kondensatoren ($C_O$–$C_n$, Figur 2; $C_O$–$C_{n+1}$, Figur 3), von denen jeweils ein Anschluß während des Wandelns an den invertierenden Eingangsanschluß des Verstärkers angeschlossen ist;

– einen Satz Schalter ($K_O$–$K_{n-1}$, Figur 2; $K_O$–$K_n$, Figur 3) zum Anschließen des anderen Anschlusses eines jeden Kondensators, mit Ausnahme des höchstwertigen ($C_n$, Figur 2; $C_{n+1}$, Figur 3), entweder an einen ersten Anschluß (A) der Schaltung oder an einen zweiten Anschluß (B), wobei der zweite Anschluß auf einem ersten Referenzpotential (Vref) liegt;

– einen zweiten Schalter (I2) zum Anschließen des ersten Anschlusses entweder an den Eingangsanschluß E+ oder an ein zweites Referenzpotential; gekennzeichnet durch einen dritten Schalter (I3) zum Anschließen des anderen Anschlusses des höchstwertigen Kondensators ($C_n$, Figur 2; $C_{n+1}$, Figur 3) entweder an den Eingangsanschluß E- oder an ein drittes Referenzpotential.

2. Wandler nach Anspruch 1, dadurch gekennzeichnet, daß das zweite und das dritte Referenzpotential Massenpotential sind.

3. Wandler nach Anspruch 2, dadurch gekennzeichnet, daß ein zusätzlicher Kondensator (C') mit einem Wert vorgesehen ist, der halb so groß ist wie derjenige des höchstwertigen Kondensators des Satzes, wobei dieser Kondensator zwischen dem ersten Referenzpotential und Masse umgeschaltet wird.

4. Wandler nach Anspruch 1, wobei das erste Referenzpotential ein positives Potential + Vref, das zweite Potential ein negatives Potential -Vref desselben Betrages wie das erste und das dritte Potential Massenpotential sind.

**Claims**

1. An analog-digital converter comprising:

– an input E+ and an input E-, as well as a ground, with an analog voltage to be converted being applied between the input E+ and the input E-;

– a high-gain differential amplifier (AMP) with a non-reversing input connected to the ground and a reversing input;

– a first switch (I1) to connect the reversing input to the ground or to disconnect the reversing input from the ground;

– a series of capacitors ($C_O$–$C_n$, Fig. 2; $C_O$–$C_{n-1}$, Fig. 3) all having a terminal connected, during the conversion, to the reversing input of the amplifier;

– a series of switches ($K_O$–$K_{n-1}$, Fig. 2; $K_O$–$K_n$, Fig. 3) to connect the other terminal of each capacitor, except the one having the highest weight ($C_n$, Fig. 2; $C_{n+1}$, Fig. 3) either to a first node (A) of the circuit or to a second node (B), the second node being connected to a first reference potential (Vref);

– a second switch (I2) to connect the first node either to the input E+ or to a second reference potential; characterized in this that it comprises a third switch (I3) to connect the other terminal of the highest-value capacitor ($C_n$, Fig. 2; $C_{n+1}$, Fig. 3) either to the input E- or to a third reference potential.

2. A converter according to claim 1, characterized in this that the second and third reference potentials are constituted by the ground.

3. A converter according to claim 2, characterized in this that it comprises an additional capacitor (C1) with a value equal to half that of the lowest-value capacitor of the series, said capacitor being switched-over between the first reference potential and the ground.

4. A converter according to claim 1, wherein the first reference potential is a positive potential + Vref, the second reference potential is a negative potential -Vref, of the same value as the first, and the third reference potential is the ground.

# FIG_1

EP 0 263 751 B1

# FIG_2

EP 0 263 751 B1

FIG_3

EP 0 263 751 B1